# EUROPÄISCHE PATENTSCHRIFT

(11) **EP 4 437 530 B1**
(45) Veröffentlichungstag und Bekanntmachung des Hinweises auf die Patenterteilung: **27.05.2026**
(21) Anmeldenummer: 23798080.0
(22) Anmeldetag: 18.10.2023
(51) Int. Cl.: G09B 9/10

(54) **VORRICHTUNG ZUR INTERAKTION EINES BENUTZERS MIT EINEM SIMULATIONSUMFELD**
DEVICE FOR AN INTERACTION BETWEEN A USER AND A SIMULATED ENVIRONMENT
DISPOSITIF POUR INTERACTION ENTRE UN UTILISATEUR ET UN ENVIRONNEMENT SIMULÉ

(30) Priorität: 16.02.2023 AT 501042023
(43) Veröffentlichungstag der Anmeldung: 02.10.2024
(73) Patentinhaber: SimVenture GmbH, 4710 Grieskirchen (AT)
(72) Erfinder: EISENKÖCK, Norman, 4710 Grieskirchen (AT)
(74) Vertreter: Hübscher & Partner Patentanwälte GmbH
(86) Internationale Anmeldenummer: PCT/AT2023/060358
(87) Internationale Veröffentlichungsnummer: WO 2024/168361

(56) Entgegenhaltungen:
- KR-B1- 102 048 517
- US-A1- 2007 171 199
- US-A1- 2019 311 645
- US-A1- 2019 318 646

## Beschreibung

### Technisches Gebiet

Die Erfindung bezieht sich auf eine Vorrichtung zur Interaktion eines Benutzers mit einem Simulationsumfeld mit einem Lagerelement für den Benutzer, das über wenigstens ein Antriebsmittel mit wenigstens einem Aktuator antriebsverbunden ist, einer Erfassungseinheit für Regeldaten und einer mit der Erfassungseinheit verbundenen Recheneinheit zum Ansteuern der Aktuatoren.

### Stand der Technik

Aus dem Stand der Technik sind Bewegungssteuerungsvorrichtungen zur Interaktion eines Benutzers mit einem Simulationsumfeld bekannt, bei denen eine Aufhängung mit einem Simulationsanzug für einen Benutzer verbunden wird (US2021228993A1). Dabei greift die Aufhängung über einen mit mehreren Zugseilen versehenen Adapter am Torso des Benutzers an, sodass dieser hochgezogen und in eine Schweblage gebracht werden kann. Kameras erfassen die Lage des Benutzers woraufhin die Zugseile angesteuert werden, um eine Verlagerung des Torsos abhängig von der Bewegung des Benutzers zu bewirken. So kann das Simulationsumfeld eines Fallschirmsprungs bzw. Skydives simuliert werden.

Aus der US20130109484A1 ist eine ähnliche Vorrichtung bekannt, die allerdings keine Kamera zur Lageerfassung aufweist.

Auch die KR1020190047311A und die EP3552970A1 zeigen ähnliche Vorrichtungen, wobei in der KR1020190047311A Druckluft über Leitelemente zu den Extremitäten des Benutzers geleitet wird und in der EP3552970A1 der gesamte Benutzer von unten mit Druckluft angeströmt wird, um gewisse Simulationsumgebungen realistischer zu gestalten.

Der Flugsimulator der KR1020180077518A zeigt ebenso einen wingsuitartigen Adapter der über Flaschenzüge schwebend aufgehängt ist.

Die US20230032506A1 zeigt eine Trageeinrichtung für Jahrmarktfahrzeuge, die über mehrere, entgegen der Gravitationsrichtung wirkende Kabel, die Teile je eines Flaschenzuges bilden, aufgehängt ist.

Nachteilig am Stand der Technik ist allerdings, dass die vom Bewegungssteuerungssystem auf den Benutzer zur Interaktion mit dem Simulationsumfeld ausübbaren Kräfte limitiert sind, da die Aufhängung lediglich vertikale, der Gravitationskraft entgegengesetzte Kräfte auf den Torso des Benutzers ausüben kann. Dadurch ist die Vielfalt bzw. Komplexität der simulierbaren Umfelder und in weiterer Folge deren Authentizitätsgrad stark eingeschränkt.

### Darstellung der Erfindung

Der Erfindung gemäß den Ansprüchen 1 und 8 liegt somit die Aufgabe zugrunde, einem Benutzer eine authentische Interaktion mit dem Simulationsumfeld unter Berücksichtigung der Bewegung seines gesamten Körpers zu ermöglichen.

Die Erfindung löst die gestellte Aufgabe dadurch, dass mehrere Lagerelemente für unterschiedliche Gliedmaßen des Benutzers vorgesehen sind, die jeweils mit zwei Aktuatoren über Antriebsmittel antriebsverbunden sind, wobei die Richtung der von wenigstens einem Aktuator auf das jeweilige Lagerelement ausübbaren Kraft von einer zur Gravitationsrichtung entgegengesetzten Richtung abweicht.

Der Erfindung liegt dabei die Überlegung zugrunde, dass die Interaktion des Benutzers mit dem Simulationsumfeld über auf die Gliedmaßen des Benutzers ausgeübte Kräfte und vice versa stattfindet. Dies wird erfindungsgemäß dadurch umgesetzt, dass mit der erfindungsgemäßen Vorrichtung auf die einzelnen Gliedmaßen in einem Regelkreis Kräfte ausgeübt werden können, deren Kraftvektoren unterschiedliche räumliche Wirkrichtungen aufweisen und nicht nur der Gravitationskraft antiparallel entgegenwirken. Für den Regelkreis ist eine Erfassungseinheit zur Erfassung von Regeldaten vorgesehen, anhand derer die Recheneinheit die Aktuatoren ansteuert. So kann die Erfassungseinheit beispielsweise eine Kamera umfassen, die die Änderung der Raumlage des Benutzers als Regeldaten erfasst, woraufhin die Recheneinheit auf Basis dieser Regeldaten einen oder mehrere Aktuatoren ansteuert, um im Sinne eines Regelkreises Kräfte auf die einzelnen Gliedmaßen des Benutzers auszuüben, wobei die Kräfte je Gliedmaße voneinander abweichen können. So lassen sich mit der erfindungsgemäßen Vorrichtung beispielsweise Schwimm- bzw. Tauchbewegungen realisieren, wenn an den Armen und Beinen des Benutzers Lagerelemente vorgesehen sind, da so der je Gliedmaße unterschiedliche Wasserwiderstand bei einer lateralen Schwimmbewegung des Benutzers simuliert werden kann. Die auf ein Lagerelement ausübbare Kraft ist vektoriell betrachtet die resultierende Kraft der von den beiden Aktuatoren über die Antriebsmittel ausgeübten Kräfte. Da die Kraftvektoren der auf die Lagerelemente ausübbaren Kräfte in der Regel entlang der Antriebsmittel verlaufen, können die Richtungen der ausübbaren resultierenden Kräfte durch die Anordung der Antriebsmittel und/oder der Aktuatoren festgelegt werden. In einer bevorzugten Ausführungsform können die zwei Aktuatoren und das mit ihnen verbundene Lagerelement in den Eckpunkten eines fiktiven Dreiecks angeordnet sein, wobei die beiden Antriebsmittel zwei der drei Seiten dieses Dreiecks bilden. Durch diese Dreiecksanordnung sind die beiden auf das Lagerelement durch die Aktuatoren ausübbaren Kräfte in ihrer Richtung linear unabhängig, wodurch eine hohe Anzahl an möglichen Kraftrichtungen ermöglicht wird. Die Aktuatoren können Seilwinden sein, die Seile als Antriebsmittel auf- und abrollen. Die Lagerelemente können beispielsweise Schlaufen sein, die um die Gliedmaßen des Benutzers gelegt werden. In einer bevorzugten Ausführungsform sind die Lagerelemente auf einem Simulationsanzug angeordnet, den der Benutzer anlegt. Um das Simulationsumfeld noch realistischer zu gestalten, kann eine optische Ausgabe, beispielsweise eine Virtual Reality-Brille, für den Benutzer vorgesehen sein, die ebenso von der Recheneinheit angesteuert wird. Im Sinne der Erfindung wird unter der von der Vorrichtung auf den Benutzer ausgeübten Kraft immer eine aktive, auf Basis der Ansteuerung der Aktuatoren ausgeübte Kraft verstanden. Dies bedeutet, dass von der Vorrichtung diese ausgeübte Kraft zusätzlich zu einer passiven Kraft, also einer Kraft, die auch in Abwesenheit der Vorrichtung auf den Benutzer wirken würde, wie beispielsweise die Gravitationskraft, auf den Benutzer wirkt. So wird beispielsweise das Beschleunigen eines Lagerelements lediglich durch die Gravitationskraft aufgrund des Leerlaufs der ihm zugeordneten Aktuatoren nicht als ausgeübte Kraft verstanden. Zwar versteht es sich für den Fachmann von selbst, dass eine Kraft naturgemäß eine vektorielle und keine skalare Größe ist, es sei aber nochmals ausdrücklich darauf hingewiesen, dass die Begriffe "Kraft" und "Kraftvektor" synonym gebraucht werden.

Zusätzlich zu den Lagerelementen kann ein Stützelement zur Einleitung des Großteiles des Körpergewichtes des Benutzers in die Vorrichtung vorgesehen sein. Dieses Stützelement kann bevorzugt im Bereich des Schwerpunkts des Benutzers angeordnet sein und kann ebenso über ein oder mehrere Antriebsmittel mit einem oder mehreren Aktuatoren verbunden sein. Dadurch, dass das Stützelement den Großteil des Körpergewichts des Benutzers aufnimmt, müssen die erfindungsgemäßen Lagerelemente vergleichsweise geringere Kräfte aufnehmen und können daher nicht nur kleiner dimensioniert werden, sondern aufgrund der damit verbundenen geringeren Masse auch schneller reagieren.

Die räumliche Erfassung des Benutzers beziehungsweise der Lagerelemente ist ausschließlich optisch ohne aufwändige technische Mittel ungenau und fehleranfällig, wodurch die Qualität der Regeldaten leidet. Um mit technisch einfachen Mitteln schnell präzise Regeldaten bestimmen zu können, wird daher vorgeschlagen, dass die Erfassungseinheit mehrere, je einem Aktuator zugeordnete Stellweggeber zur Erfassung seines Stellwegs als Regeldaten umfasst. Zufolge dieser Maßnahmen kann der leicht ermittelbare Stellweg des Aktuators, also beispielsweise die Auslenkung eines Linearmotors oder der Abrollstatus einer Seilwinde, als Regeldaten bestimmt werden. Diese Regeldaten können in der Recheneinheit verarbeitet und dadurch die Lage des Benutzers und folglich die auszuübenden Kräfte bestimmt werden. Aus diesen Zustandsgrößen kann beispielsweise einfach die relative Lage des Benutzers bestimmt werden. Bevorzugterweise wird vor dem Start der Interaktion des Benutzers mit dem Simulationsumfeld die Vorrichtung kalibriert, da sich so auch die absolute Lage des Benutzers in einem definierten Koordinatensystem bestimmen lässt. Dies kann beispielsweise durch das Festlegen einer definierten Startposition für den Benutzer und anschließendem Nullsetzen aller Zustandsgrößen erfolgen.

Soll im Simulationsumfeld schnell und einfach als Reaktion auf eine ausgeübte Kraft vom Benutzer eine Kraft von der Vorrichtung auf den Benutzer ausgeübt werden, kann dies mit technisch einfachen Mitteln analog zur Erfassung des Stellweges dadurch umgesetzt werden, dass die Erfassungseinheit mehrere, je einem Aktuator zugeordnete Stellkraftgeber zur Erfassung der Stellkraft als Regeldaten umfasst. In diesem Fall werden die vom Benutzer auf den Aktuator ausgeübten Kräfte als Stellkräfte vom Stellkraftgeber als Regeldaten bestimmt und analog zu oben verarbeitet. Dies ermöglicht beispielsweise das bereits oben beschriebene Simulieren einer Schwimmbewegung: Registriert der Stellkraftgeber in den den Armen zugeordneten Aktuatoren eine Schwimmbewegung, dienen die ausgeübten Kräfte dieser Schwimmbewegung als Regeldaten, die über den Stellkraftgeber erfasst werden und die Recheneinheit bestimmt die von den Aktuatoren auf den Benutzer auszuübenden Gegenkräfte, die den Wasserwiderstand simulieren.

Auch wenn die am Aktuator bestimmten Stellgrößen einfach und genau bestimmt werden können, werden für manche Simulationsumfelder Regeldaten benötigt, die nicht über den Aktuator bestimmt werden können. Um solche Regeldaten dennoch zu bestimmen oder um Korrekturdaten für Gliedmaßen zu erhalten, denen ein Lagerelement zugeordnet ist, wird vorgeschlagen, dass die Erfassungseinheit eine optische Aufnahmeeinrichtung zur Bestimmung der die Raumlage wenigstens eines Körperteils des Benutzers als Regeldaten umfasst. Zufolge dieser Maßnahmen können nämlich auch Körperteile bzw. Bewegungen erfasst werden, die über einen Stellweggeber oder einen Stellkraftgeber evtl. nicht erfasst werden können, wie beispielsweise die Lage von Körperteilen, für die kein Lagerelement vorgesehen ist oder Rotationsbewegungen von Körpergliedern. Die so erfasste Raumlage kann als Regeldaten der Recheneinheit zugeführt werden. Alternativ oder zusätzlich können so gewonnene Regeldaten als Korrektur zu den über den Aktuator, beispielsweise über einen Stellweggeber oder einen Stellkraftgeber, erfassten Regeldaten verwendet werden.

Um ein Simulationsumfeld umzusetzen, in dem die Gravitation höher als die Erdgravitation ist, kann wenigstens ein Aktuator eines Lagerelements so angeordnet sein, dass die von ihm auf das Lagerelement ausübbare Kraft eine in Gravitationsrichtung verlaufende Komponente umfasst. Zufolge dieser Maßnahmen kann eine Kraft auf das Lagerelement ausgeübt werden, die eine zum Gravitationsvektor parallele Kraftkomponente umfasst und dadurch die Gravitationskraft verstärkt. In einer besonders platzsparenden und einfach anzusteuernden Ausführungsform liegen beide Aktuatoren und das Lagerelement auf einer fiktiven Linie, die von den Aktuatoren begrenzt wird, sodass die Antriebsmittel beider Aktuatoren parallel zum Gravitationsvektor verlaufen.

Um eine Bewegung der Körperglieder ohne den Einfluss aktiver Kräfte quer zum Gravitationsvektor zu ermöglichen, ohne einen Aktuator betätigen zu müssen, wird vorgeschlagen, dass wenigstens ein Aktuator quer zum Gravitationsvektor verlagerbar auf einer Trageplattform gelagert ist. Dadurch kann der Benutzer die Aktuatoren quer zum Gravitationsvektor, also waagerecht, mitbewegen, ohne dass diese diese laterale Bewegung durch einen Stellweg ausgleichen müssen. Durch die Trageplattform ergibt sich weiterhin der Vorteil, dass die Aktuatoren und auch ein eventuell vorhandenes Stützelement einfach gelagert werden können. Die Aktuatoren können passiv, also ohne weiteren Antrieb gelagert sein, sodass sie der Bewegung des Körperglieds durch die vom Benutzer auf den Aktuator ausgeübten Zugkräfte folgen. In einer bevorzugten Ausführungsform sind die Aktuatoren aber so gelagert, dass sie aktiv gelagert sind, also über einen Antrieb verfügen, mit dem sie verlagert werden können. Dadurch kann über diesen Antrieb eine weitere Kraft auf den Benutzer ausgeübt werden. Noch bevorzugterweise kann dieser Antrieb in einen Leerlauf geschaltet werden, der eine Bewegung wie bei einer passiven Lagerung ermöglicht.

Wird eine Trageplattform verwendet, können möglicherweise nicht alle Aktuatoren auf dieser gelagert werden, um eine Vielzahl an möglichen ausübbaren Kräften zu realisieren. Werden allerdings zwei sich bezüglich der Lagerelemente gegenüberliegende Trageplattformen zum Lagern wenigstens eines Aktuators vorgesehen, können die Aktuatoren auf beide Trageplattformen verteilt werden, wodurch sich die Möglichkeit ihrer räumlichen Anordnung und damit die Anzahl an möglichen ausübbaren Kräften erhöht. Eine Symmetrie der Anordnung ermöglicht dabei nach wie vor eine verhältnismäßig einfache Ansteuerung der Aktuatoren zum Erzeugen der gewünschten resultierenden Kräfte.

Um für den Benutzer auch Roll-, Nick- und/oder Gierbewegungen zu ermöglichen, wird vorgeschlagen, dass wenigstens eine Trageplattform um eine Drehachse schwenkbar gelagert ist. So können die Aktuatoren einer Trageplattform zusammen und gleichzeitig mit der Trageplattform verschwenkt werden und eine Verlagerung des gesamten Körpers des Benutzers bewirken. Zwar können diese Bewegungen bei entsprechender Anordnung der Aktuatoren bzw. der Antriebsmittel auch ohne schwenkbarer Trageplattform realisiert werden, ist allerdings erfindungsgemäß die Trageplattform schwenkbar gelagert, müssen dazu die Aktuatoren nicht separat angesteuert werden, wodurch sich die Ansteuerung der Vorrichtung vereinfacht. Sind zwei Trageplattformen vorgesehen, so sind bevorzugterweise beide um eine gemeinsame Achse schwenkbar.

Die Erfindung betrifft auch ein Verfahren zum Betreiben einer oben beschriebenen Vorrichtung zur Interaktion eines menschlichen Körpers mit einem Simulationsumfeld, wobei die Recheneinheit anhand der Regeldaten und einem dem Simulationsumfeld zugeordneten Kinematikmodell Vorgabewerte für die Aktuatoren ermittelt, wonach die Aktuatoren anhand dieser Vorgabewerte angesteuert werden. Die Recheneinheit erhält die Regeldaten der Erfassungseinheit und damit die Information über Lage bzw. wirkende Kräfte der Lagerelemente und evtl. weiterer Körperteile des Benutzers. Im Kinematikmodell sind die im Simulationsumfeld herrschenden relevanten physikalischen Zusammenhänge und Gesetzmäßigkeiten repräsentiert, sodass die Recheneinheit bestimmen kann, wie sich eine Aktion des Benutzers im Simulationsumfeld auswirkt und welche eventuellen Gegenkräfte auf ihn wirken sollen. So kann das Kinematikmodell beispielsweise ein Vektorfeld umfassen, das jedem Raumpunkt, in dem sich der Benutzer im Simulationsumfeld bewegen kann, einen Vektor zuordnet. Im einfachsten Fall kann so eine Umgebung mit geringer Gravitation simuliert werden, indem jedem Raumpunkt ein dem Gravitationsvektor entgegenwirkender Kraftvektor zugeordnet wird. Die Recheneinheit kann nun aufgrund der durch die Regeldaten gewonnen Information der Position eines Lagerelements und dem Abrufen des diesem Punkt zugeordnetes Vorgabewerts eine entsprechende auszuübende Kraft auf das Lagerelement bestimmen und die jeweiligen Aktuatoren so ansteuern, dass diese Kraft auf das Lagerelement ausgeübt wird. Allgemein betrachtet kann also im Kinematikmodell eine Zuordnung zwischen den als Regelungsdaten erfassten Kräften und einem resultierenden Stellweg als Vorgabewert für einen oder mehrere Aktuatoren erfolgen.

### Kurze Beschreibung der Erfindung

In der Zeichnung ist der Erfindungsgegenstand beispielsweise dargestellt. Es zeigen
- Fig. 1: eine schematische Seitenansicht einer erfindungsgemäßen Vorrichtung mit einem Benutzer,
- Fig. 2: eine schematische Vorderansicht der erfindungsgemäßen Vorrichtung der Fig. 1.

### Wege zur Ausführung der Erfindung

Eine erfindungsgemäße Vorrichtung umfasst mehrere Lagerelemente 1, über die Kräfte vom und auf den Benutzer 2 ausgeübt werden, um mit dem Simulationsumfeld zu interagieren und die für mehrere Gliedmaßen des Benutzers 2 vorgesehen sind. Die Lagerelemente 1 sind über Antriebsmittel 3 mit Aktuatoren 4 antriebsverbunden. Im gezeigten Ausführungsbeispiel sind die Lagerelemente 1 Schlaufen, die der Benutzer 2 um die Gliedmaßen trägt. Um zu bestimmen, welche Kräfte auf den Benutzer 2 in Abhängigkeit seiner Lage bzw. seiner Bewegungen von der Vorrichtung auf den Benutzer 2 ausgeübt werden sollen, ist eine Erfassungseinheit vorgesehen, die Regeldaten erfasst und anhand dieser Regeldaten und einem dem Simulationsumfeld zugeordneten Kinematikmodells Vorgabewerte für die Aktuatoren 4 ermittelt auf deren Basis eine Recheneinheit 5 die Aktuatoren 4 ansteuert. Im gezeigten Ausführungsbeispiel sind die Aktuatoren 4 Seilwinden, die Seile als Antriebsmittel 3 auf- und abrollen. Die Erfassungseinheit umfasst Stellweggeber 6 und Stellkraftgeber 7, die den Stellweg bzw. die Stellkraft der Aktuatoren 4 als Regeldaten umfassen und im gezeigten Ausführungsbeispiel in einem konzentrisch zu den Seilwinden angebrachten Gehäusen angeordnet sind.

Um Kräfte auf den Benutzer 2 auszuüben, die in ihrer Ausrichtung von einer zur Gravitationsrichtung 8 antiparallelen Richtung abweichen, sind für mehrere Lagerelemente 1 jeweils zwei Aktuatoren 4 vorgesehen, wobei in den gezeigten Ausführungsbeispielen auch je ein Antriebsmittel 3 für jeden Aktuator 4 vorgesehen ist. Durch die gezeigte Anordnung der Aktuatoren 4 und Antriebsmittel 3 in den gezeigten Ausführungsbeispielen können manche Gliedmaßen in Gravitationsrichtung 8 nach unten gezogen werden, da die auf diese Gliedmaßen ausübbare Kraft eine in Gravitationsrichtung 8 verlaufende Komponente umfasst. Andere Lagerelemente 1 können quer zur Gravitationsrichtung 8 verlagert werden, indem für diese Lagerelemente 1 Aktuatoren 4 vorgesehen sind, die mit dem Lagerelement 1 in einem Dreieck angeordnet sind, sodass linear unabhängige Kraftvektoren auf diese Lagerelemente 1 ausgeübt werden können.

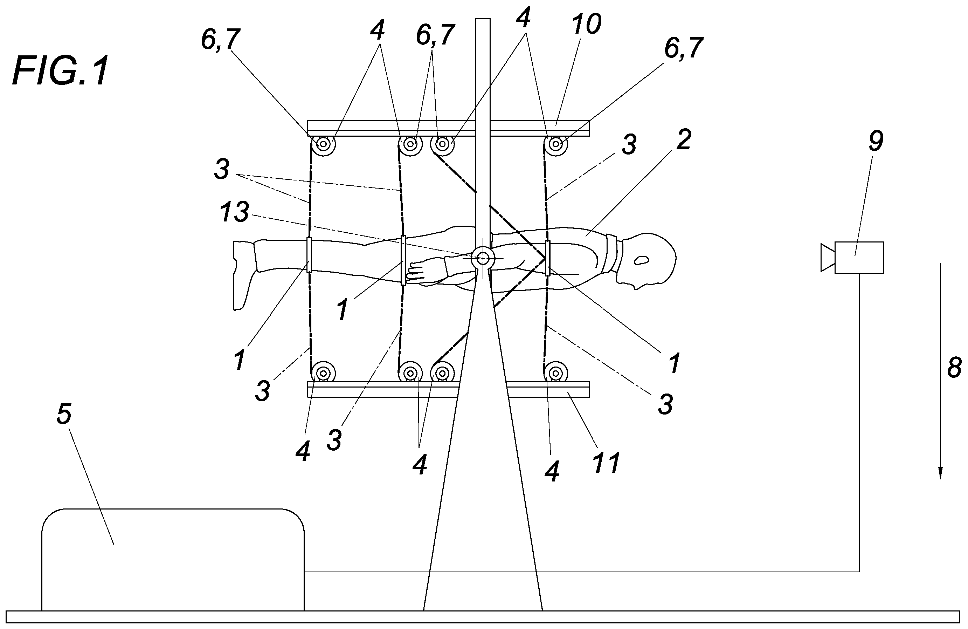

Zur realistischen Darstellung mancher Simulationsumfelder reichen die von der Erfassungseinheit über die Lagerelemente 1 erfassten Regeldaten nicht aus, weswegen die Erfassungseinheit eine optische Aufnahmeeinrichtung 9, in den gezeigten Ausführungsbeispielen eine Kamera, umfassen kann, die die Raumlage wenigstens eines Körperteils des Benutzers 2 bestimmt. Aus perspektivischen Gründen wurde die Kamera nur in Fig. 1 dargestellt. Bei dem Körperteil kann es sich ebenso um Gliedmaßen handeln, es kann aber auch beispielsweise der Torso des Benutzers 2 erfasst werden. Dadurch kann die auf den Benutzer 2 über die Lagerelemente 1 auszuübende Kraft auch durch Regeldaten geregelt werden, die nicht über die Lagerelemente 1 erhalten werden.

Die Aktuatoren 4 sind im gezeigten Ausführungsbeispiel auf einer Trageplattform 10 angeordnet, wodurch die Aktuatoren 4 quer zur Gravitationsrichtung 8 verlagerbar sind. Die Aktuatoren 4 können auf der Trageplattform auf Schienen oder bevorzugterweise auf einem Kreuzschlitten gelagert sein, sodass die Aktuatoren 4 durch Krafteinwirkung des Benutzers 2 verlagert werden können. Bevorzugterweise sind aktive Antriebsmittel für die Aktuatoren 4 vorgesehen, sodass über die Aktuatoren 4 auch eine quer zum Gravitationsvektor 8 wirkende Kraftkomponente auf die den Aktuatoren 4 zugeordneten Lagerelemente 1 ausgeübt werden kann. Um die Positioniermöglichkeiten der Aktuatoren 4 bzw. Antriebsmittel 3 zu erhöhen und damit eine größere Vielfalt an auszuübenden Kräften zu ermöglichen, können zwei Trageplattformen 10, 11 vorgesehen sein, die sich bezüglich den Lagerelementen 1 gegenüberliegen.

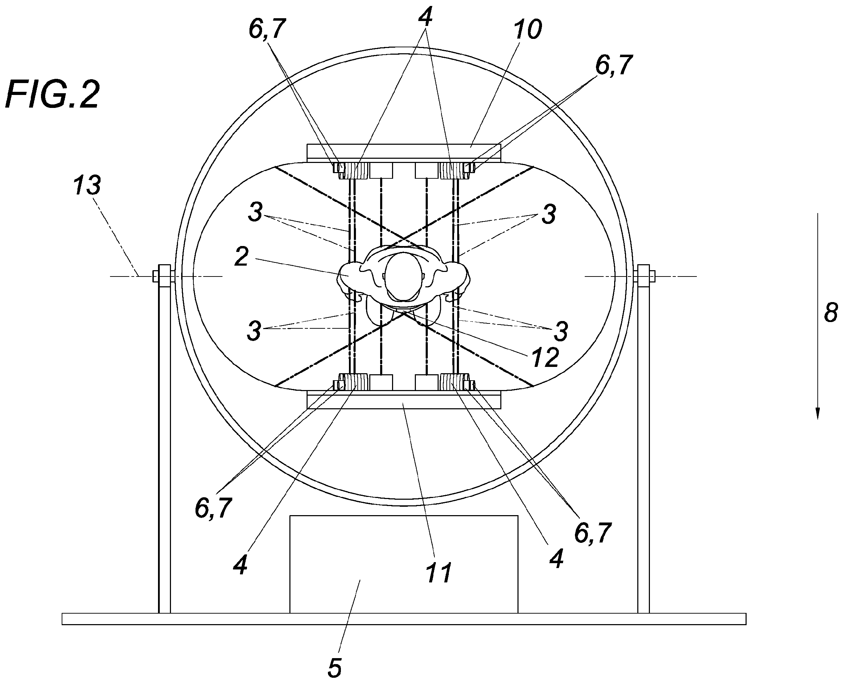

Wie der Fig. 2 entnommen werden kann, ist im gezeigten Ausführungsbeispiel im Bereich des Schwerpunkts des Benutzers ein Stützelement 12 vorgesehen, über das der Großteil des Körpergewichts des Benutzers 2 in die Vorrichtung eingeleitet werden kann, sodass nicht das gesamte Körpergewicht über die Lagerelemente 1 in die Vorrichtung eingeleitet werden muss.

Im gezeigten Ausführungsbeispiel sind beide Trageplattformen 10, 11 schwenkbar um die Drehachse 13 gelagert, sodass Nickbewegungen über die Trageplattformen 10, 11 realisiert werden können.

## Patentansprüche

1. Vorrichtung zur Interaktion eines Benutzers (2) mit einem Simulationsumfeld mit einem Lagerelement (1) für den Benutzer (2), das über wenigstens ein Antriebsmittel (3) mit wenigstens einem Aktuator (4) antriebsverbunden ist, einer Erfassungseinheit für Regeldaten und einer mit der Erfassungseinheit verbundenen Recheneinheit (5) zum Ansteuern der Aktuatoren (1), wobei mehrere Lagerelemente (1) für unterschiedliche Gliedmaßen des Benutzers (2) vorgesehen sind, die jeweils mit zwei Aktuatoren (4) über Antriebsmittel (3) antriebsverbunden sind, wobei die Richtung der von wenigstens einem Aktuator (4) auf das jeweilige Lagerelement (1) ausübbaren Kraft von einer zur Gravitationsrichtung (8) entgegengesetzten Richtung abweicht, **dadurch gekennzeichnet, dass** die Erfassungseinheit mehrere, je einem Aktuator (4) zugeordnete Stellweggeber (6) zur Erfassung seines Stellwegs als Regeldaten und mehrere, je einem Aktuator (4) zugeordnete Stellkraftgeber (7) zur Erfassung der Stellkraft als Regeldaten umfasst.

2. Vorrichtung nach Anspruch 1, **dadurch gekennzeichnet, dass** ein Stützelement (12) zur Einleitung des Großteiles des Körpergewichtes des Benutzers (2) in die Vorrichtung vorgesehen ist.

3. Vorrichtung nach Anspruch 1 oder 2, **dadurch gekennzeichnet, dass** die Erfassungseinheit eine optische Aufnahmeeinrichtung (9) zur Bestimmung der Raumlage wenigstens eines Körperteils des Benutzers (2) als Regeldaten umfasst.

4. Vorrichtung nach einem der Ansprüche 1 bis 3, **dadurch gekennzeichnet, dass** wenigstens ein Aktuator (4) eines Lagerelements (1) so angeordnet ist, dass die von ihm auf das Lagerelement (1) ausübbare Kraft eine in Gravitationsrichtung (8) verlaufende Komponente umfasst.

5. Vorrichtung nach einem der Ansprüche 1 bis 4, **dadurch gekennzeichnet, dass** wenigstens ein Aktuator (4) quer zur Gravitationsrichtung (8) verlagerbar auf einer Trageplattform (10) gelagert ist.

6. Vorrichtung nach einem der Ansprüche 1 bis 5, **dadurch gekennzeichnet, dass** zwei sich bezüglich der Lagerelemente (1) gegenüberliegende Trageplattformen (10, 11) zum Lagern wenigstens eines Aktuators (4) vorgesehen sind.

7. Vorrichtung nach einem der Ansprüche 5 oder 6, **dadurch gekennzeichnet, dass** wenigstens eine Trageplattform (10) um eine Drehachse (13) schwenkbar gelagert ist.

8. Verfahren zum Betreiben einer Vorrichtung nach einem der vorangegangenen Ansprüche, wobei die Recheneinheit (5) anhand der Regeldaten und einem dem Simulationsumfeld zugeordneten Kinematikmodell Vorgabewerte für die Aktuatoren (4) ermittelt, wonach die Aktuatoren (4) anhand dieser Vorgabewerte angesteuert werden.

## Claims

1. Device for interaction between a user (2) and a simulation environment, comprising a rest element (1) for the user (2), which is connected via at least one drive means (3) to at least one actuator (4), a detection unit for control data and a computing unit (5) connected to the detection unit for controlling the actuators (1), wherein a plurality of rest elements (1) are provided for different limbs of the user (2), each of which rest elements (1) is connected to two actuators (4) via drive means (3), wherein the direction of the force exerted by at least one actuator (4) on the respective rest element (1) deviates from a direction opposite to the direction of gravity (8), **characterized in that** the detection unit comprises a plurality of position sensors (6) assigned to each actuator (4) for detecting its position as control data, and a plurality of actuating force sensors (7) assigned to each actuator (4) for detecting the actuating force as control data.

2. Device according to claim 1, **characterized in that** a support element (12) is provided for transferring the majority of the body weight of the user (2) into the device.

3. Device according to claim 1 or 2, **characterized in that** the detection unit comprises an optical recording device (9) for determining the spatial position of at least one part of the body of the user (2) as control data.

4. Device according to one of claims 1 to 3, **characterized in that** at least one actuator (4) of a rest element (1) is arranged such that the force it can exert on the rest element (1) includes a component running in the direction of gravity (8).

5. Device according to one of claims 1 to 4, **characterized in that** at least one actuator (4) is mounted on a carrier platform (10) so that it can be moved transversely to the direction of gravity (8).

6. Device according to one of claims 1 to 5, **characterized in that** two carrier platforms (10, 11) opposite each other with respect to the rest elements (1) are provided for mounting at least one actuator (4).

7. Device according to one of claims 5 or 6, **characterized in that** at least one carrier platform (10) is mounted so as to be pivotable about a pivot axis (13).

8. Method for operating a device according to one of the preceding claims, wherein the computing unit (5) determines set values for the actuators (4) on the basis of the control data and a kinematic model assigned to the simulation environment, after which the actuators (4) are controlled on the basis of these set values.

## Revendications

1. Dispositif pour interaction entre un utilisateur (2) et un environnement simulé, comprenant un élément de support (1) pour l'utilisateur (2), ledit élément de support étant relié par entraînement à au moins un actionneur (4) par l'intermédiaire d'au moins un moyen d'entraînement (3), une unité de détection pour des données de commande et une unité de calcul (5) reliée à l'unité de détection afin de commander les actionneurs (1), plusieurs éléments de support (1) étant prévus pour différents membres de l'utilisateur (2), chaque élément de support étant relié par l'intermédiaire de moyens d'entraînement (3) à deux actionneurs (4), la direction de la force pouvant être exercée par au moins un actionneur (4) sur l'élément de support (1) respectif s'écartant d'une direction opposée à la direction de la gravité (8), **caractérisé en ce que** l'unité de détection comprend plusieurs capteurs de course (6) associés chacun à un actionneur (4) pour détecter sa course en tant que données de commande et plusieurs capteurs de force (7) associés chacun à un actionneur (4) pour détecter la force de réglage en tant que données de commande.

2. Dispositif selon la revendication 1, **caractérisé en ce qu'**un élément de support (12) est prévu pour transférer la majeure partie du poids corporel de l'utilisateur (2) dans le dispositif.

3. Dispositif selon la revendication 1 ou 2, **caractérisé en ce que** l'unité de détection comprend un dispositif de prise de vue optique (9) pour déterminer la position spatiale d'au moins une partie du corps de l'utilisateur (2) en tant que données de commande.

4. Dispositif selon l'une des revendications 1 à 3, **caractérisé en ce qu'**au moins un actionneur (4) d'un élément de support (1) est disposé de telle sorte que la force qu'il peut exercer sur l'élément de support (1) comprend une composante s'étendant dans la direction de la gravité (8).

5. Dispositif selon l'une des revendications 1 à 4, **caractérisé en ce qu'**au moins un actionneur (4) est monté de manière à pouvoir se déplacer transversalement à la direction de gravité (8) sur une plate-forme de support (10).

6. Dispositif selon l'une des revendications 1 à 5, **caractérisé en ce que** deux plates-formes de support (10, 11) opposées par rapport aux éléments de support (1) sont prévues pour supporter au moins un actionneur (4).

7. Dispositif selon l'une des revendications 5 ou 6, **caractérisé en ce qu'**au moins une plate-forme de support (10) est montée de manière pivotante autour d'un axe de rotation (13).

8. Procédé pour faire fonctionner un dispositif selon l'une des revendications précédentes, dans lequel l'unité de calcul (5) détermine des valeurs de consigne pour les actionneurs (4) à l'aide des données de commande et d'un modèle cinématique associé à l'environnement simulé, après quoi les actionneurs (4) sont commandés à l'aide de ces valeurs de consigne.
